(19) Europäisches Patentamt
European Patent Office
Office européen des brevets

(11) EP 2 824 534 A2

(12) **EUROPEAN PATENT APPLICATION**

(43) Date of publication:
14.01.2015 Bulletin 2015/03

(51) Int Cl.:
*G05F 3/20* (2006.01)

(21) Application number: 14176094.2

(22) Date of filing: 08.07.2014

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 11.07.2013 US 201361845176 P
22.04.2014 US 201414258926

(71) Applicant: Samsung Display Co., Ltd.
Gyeonggi-Do (KR)

(72) Inventor: Jaffari, Nasrin
San Jose, CA California 95112 (US)

(74) Representative: Mounteney, Simon James
Marks & Clerk LLP
90 Long Acre
London
WC2E 9RA (GB)

(54) **Bulk-modulated current source**

(57) A bulk-modulated current source includes: an output terminal configured to supply an output current; a first transistor comprising: a first electrode coupled to the output terminal, a second electrode, a bulk electrode, and a gate electrode configured to receive a bias voltage; and an amplifier comprising: an input terminal electrically coupled to the first electrode of the first transistor, and an output terminal electrically coupled to the bulk electrode of the first transistor.

FIG. 4α

EP 2 824 534 A2

**Description**

**BACKGROUND**

**1. Field**

The present invention is related to a system and method for providing a bulk-modulated current source.

**2. Description of Related Art**

Current sources operate in electronic circuits to provide or receive an electrical current. An ideal current source provides a constant current output regardless of the voltage applied across the ideal current source. Thus, an ideal current source has infinite output impedance. In practical application, however, all current sources have a finite impedance. Thus, the current output by a current source inherently varies in accordance with variations in the voltage across the current source, due to the finite output impedance of real-world components. In many different fields, however, it is desirable to implement a current sources having a relatively high output impedance while still having a relatively small physical area.

**SUMMARY**

Aspects of embodiments of the present invention seek to provide a system and method for providing a current source having a relatively high output impedance and a relatively small physical area or footprint.

According to one embodiment of the present invention, a bulk-modulated current source includes: an output terminal configured to supply an output current; a first transistor comprising: a first electrode coupled to the output terminal, a second electrode, a bulk electrode, and a gate electrode configured to receive a bias voltage; and an amplifier comprising: an input terminal electrically coupled to the first electrode of the first transistor, and an output terminal electrically coupled to the bulk electrode of the first transistor.

The amplifier may have a negative gain.

The negative gain of the amplifier may be in a range of -0.5 to -2.

The amplifier may include: a second transistor including: a gate electrode electrically coupled to the first electrode of the first transistor, and a drain electrode electrically coupled to the output terminal of the amplifier; and a third transistor including: a source electrode electrically coupled to a power supply, a gate electrode, and a drain electrode, wherein the drain electrode of the third transistor may be electrically coupled to the gate electrode of the third transistor and the drain electrode of the second transistor.

The first transistor may be an NMOS transistor, and the second electrode may be coupled to a low voltage power supply or ground.

The first transistor may be a PMOS transistor, and the second electrode may be coupled to a high voltage power supply.

According to one embodiment of the present invention, a bulk-modulated current source includes: a first transistor comprising: a first electrode, and a bulk electrode; and an amplifier comprising: an input terminal electrically coupled to the first electrode of the first transistor, and an output terminal electrically coupled to the bulk electrode of the first transistor.

The bulk-modulated current source may further include an output terminal configured to supply an output current and coupled to the first electrode.

The first transistor may further include a gate electrode configured to receive a bias voltage.

The amplifier may have a negative gain.

The negative gain of the amplifier may be in a range of -0.5 to -2.

The amplifier may further include: a second transistor including: a gate electrode electrically coupled to the first electrode of the first transistor, and a drain electrode electrically coupled to the output terminal of the amplifier; and a third transistor including: a source electrode electrically coupled to a power supply, a gate electrode, and a drain electrode, wherein the drain electrode of the third transistor may be electrically coupled to the gate electrode of the third transistor and the drain electrode of the second transistor.

The first transistor may be an NMOS transistor, and a second electrode of the first transistor may be coupled to a low voltage power supply or ground.

According to one embodiment of the present invention, in a method of generating an output current using a bulk-modulated current source, the method includes: generating an output current at an output terminal of the bulk-modulated current source by applying a bias voltage to a gate electrode of a first transistor of the bulk-modulated current source, wherein a first electrode of the first transistor is electrically coupled to the output terminal of the bulk-modulated current source; supplying an input terminal of an amplifier with a first output voltage corresponding to the output current; and driving a bulk terminal of the first transistor with a second output voltage generated by the amplifier.

The amplifier may have a negative gain.

The negative gain of the amplifier may be in a range of -0.5 to -2.

The amplifier may further include: a second transistor including: a gate electrode electrically coupled to the first electrode of the first transistor, and a drain electrode electrically coupled to the output terminal of the amplifier; and a third transistor including: a source electrode electrically coupled to a power supply, a gate electrode, and a drain electrode, wherein the drain electrode of the third transistor may be electrically coupled to the gate electrode of the third transistor and the drain electrode of the second transistor.

The first transistor may be an NMOS transistor, and a second electrode of the first transistor may be coupled to a low voltage power supply or ground.

The first transistor may be a PMOS transistor, and a second electrode of the first transistor may be coupled to a high voltage power supply.

At least some of the above and other features of the invention are set-out in the claims.

## BRIEF DESCRIPTION OF THE DRAWINGS

A more complete appreciation of the present invention, and many of the attendant features and aspects thereof, will become more readily apparent as the invention becomes better understood by reference to the following detailed description when considered in conjunction with the accompanying drawings in which like reference symbols indicate like components.

FIGs. 1a and 1b illustrate a current source having a single small channel transistor and how the corresponding output current changes in relation to changes in voltage.

FIGs. 2a and 2b illustrate a current source having a single long channel transistor and how the corresponding output current changes in relation to changes in voltage.

FIGs. 3a and 3b illustrate a cascode current source and how the corresponding output current changes in relation to changes in voltage.

FIGs. 4a-4d illustrate a bulk-modulated current source and how the corresponding output current changes in relation to changes in voltage, according to an example embodiment of the present invention.

## DETAILED DESCRIPTION

The detailed description set forth below in connection with the appended drawings is intended as a description of embodiments of the present invention and is not intended to represent the only forms in which the present invention may be constructed or utilized. The description sets forth the features of the present invention in connection with the illustrated embodiments. It is to be understood, however, that the same or equivalent functions and structures may be accomplished by different embodiments that are also intended to be encompassed within the scope of the invention. As denoted elsewhere herein, like element numbers are intended to indicate like elements or features. Expressions such as "at least one of," when preceding a list of elements, modify the entire list of elements and do not modify the individual elements of the list. Further, the use of "may" when describing embodiments of the present invention refers to "one or more embodiments of the present invention."

In many different applications, current sources operate to provide electrical current in electrical devices. An ideal current source has an infinite output impedance such that the output current is insensitive to changes in voltage at the output terminal. In reality, current sources have a finite output impedance such that the output current changes in relation to changes in voltage at the output terminal. The output impedance of a current source may be increased, for example, by increasing the channel size of transistors utilized in the current source, but only at the expense of increasing the overall physical area of the current source. Thus, in many applications, where it is desirable to reduce the overall size of electrical devices, there may be a corresponding desire for providing a current source having a relatively high output impedance while still maintaining a relatively small physical area.

When short channel transistors are utilized in a current source, the output current of the transistor biased in saturation changes with its drain-to-source voltage due to short channel effects, represented according to the equation (1), below:

$$I_{Dsat} = k \cdot \frac{W}{2L} \cdot (V_{GS} - V_T)^2 \cdot (1 + \lambda \cdot V_{DS}) \qquad (1)$$

where $I_{Dsat}$ is the current of the transistor biased in saturation, and k is a constant equal to $\mu \cdot C_{OX}$, where $\mu$ is the mobility

and $C_{OX}$ is the oxide capacitance. $W$ is the channel width of the transistor, L is the channel length of the transistor, $V_{GS}$ is the gate-to-source voltage, $V_T$ is the threshold voltage, $\lambda$ is the channel-length modulation parameter, and $V_{DS}$ is the drain-to-source voltage.

Additionally, the threshold voltage of a transistor is a function of its source-to-bulk voltage, as represented according to equation (2), below:

$$V_T = V_{T0} + \gamma(\sqrt{V_{SB} + 2\phi_F} - \sqrt{2\phi_F} \qquad (2)$$

where $V_{T0}$ is the threshold voltage when $V_{SB} = 0$, $\gamma$ is the body effect parameter, $V_{SB}$ is the source-to-bulk voltage and $\phi_F$ is the surface potential.

Accordingly, as is evident from equations (1) and (2), above, in short channel transistors, $I_{Dsat}$ depends on $V_{DS}$. That is, the current $I_{Dsat}$ increases or decreases as the drain-to-source voltage $V_{DS}$ increases or decreases. Furthermore, as the source-to-bulk voltage $V_{SB}$ increases or decreases, $V_T$ correspondingly increases or decreases, and therefore the current $I_{Dsat}$ decreases or increases.

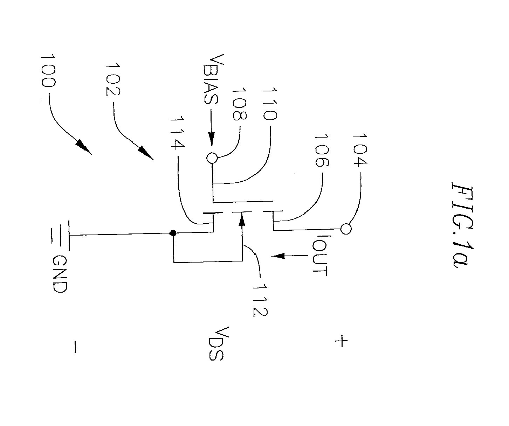

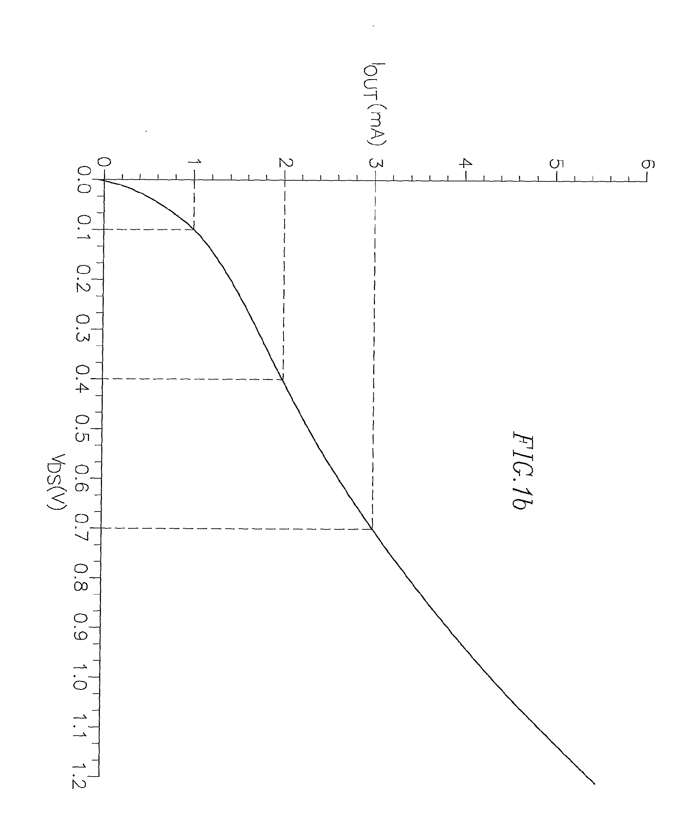

FIG. 1 a illustrates a current source 100 including a small channel transistor 102. The current source 100 has an output terminal 104 electrically coupled to a drain electrode 106 of the small channel transistor 102. The current source 100 further has a bias voltage input terminal 108 electrically coupled to a gate electrode 110 of the small channel transistor 102, and a bias voltage $V_{BIAS}$ may be applied to the bias voltage input terminal 108 to facilitate generation of the output current $I_{OUT}$ at the output terminal 104. A bulk electrode 112 of the small channel transistor 102 is electrically coupled to a source electrode 114 of the small channel transistor 102, which is further coupled to a low voltage power supply or ground GND.

The small channel transistor 102 may be manufactured using any suitable manufacturing or fabrication technology and the current source 100 may be configured to provide an output current $I_{OUT}$ according to the design and function of the current source 100, depending on the bias voltage $V_{BIAS}$. For example, the current source 100 may be designed to provide an output current $I_{OUT}$ of approximately 1 milliamp (mA).

In order to reduce or minimize the footprint of the current source 100, the small channel transistor 102 has relatively small channel dimensions, for example, with a channel width $W$ of 200 micrometers ($\mu$m) and a channel length L of 60 nanometers (nm). Thus, the total physical area or footprint of the current source 100 may be approximately 12 square micrometers ($\mu$m$^2$).

As discussed, however, in small channel devices, the current $I_{OUT}$ is sensitive to changes in the voltage $V_{DS}$ across the small channel transistor 102. In accordance with the above-described relationship between the current of small channel transistors and the voltage $V_{DS}$ across the transistors, FIG. 1b illustrates the current $I_{OUT}$ at the output terminal 104 of the current source 100 in relation to the voltage $V_{DS}$ across the small channel transistor 102. As shown in FIG. 1b, the current $I_{OUT}$ at the output terminal 104 of the current source 100, depending on the bias voltage $V_{BIAS}$, may be, for example, approximately 1 mA, when the voltage $V_{DS}$ across the drain electrode 106 and source electrode 114 of the small channel transistor 102 is approximately 0.1 volts (V).

Due to the small channel effects of the small channel transistor 102 discussed above with respect to equations (1) and (2), the current $I_{OUT}$ increases in proportion to increases in the voltage $V_{DS}$. Thus, the output current $I_{OUT}$ of the current source 100 including the small channel transistor 102 having a channel width $W$ of, for example, 200 $\mu$m and a channel length L of, for example, 60 nm may increase from approximately 1 mA to approximately 2 mA as the voltage $V_{DS}$ increases from approximately 0.1 V to approximately 0.4 V. As the voltage $V_{DS}$ further increases from approximately 0.4 V to approximately 0.7 V, the output current $I_{OUT}$ of the current source 100 may continue to increase from approximately 2 mA to approximately 3 mA. Accordingly, the output current $I_{OUT}$ of the current source 100 is relatively sensitive to changes in the voltage $V_{DS}$ across the small channel transistor 102, and therefore has a relatively low output impedance.

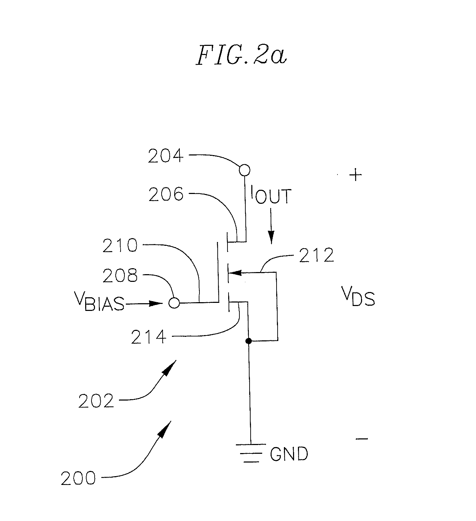

FIG. 2a illustrates a current source 200 including a long channel transistor 202. The current source 200 has an output terminal 204 electrically coupled to a drain electrode 206 of the long channel transistor 202. The current source 200 further has a bias voltage input terminal 208 electrically coupled to a gate electrode 210 of the long channel transistor 202, and a bias voltage $V_{BIAS}$ may be applied to the bias voltage input terminal 208 to facilitate generation of the output current $I_{OUT}$ at the output terminal 204. A bulk electrode 212 of the long channel transistor 202 is electrically coupled to a source electrode 214 of the long channel transistor 202, which is further coupled to a low voltage power supply or ground GND.

The long channel transistor 202 may be manufactured using any suitable transistor manufacturing or fabrication technology and the current source 200 may be configured to provide an output current $I_{OUT}$ according to the design and function of the current source 200 depending on the bias voltage $V_{BIAS}$. For example, the current source 200 may be designed to provide an output current $I_{OUT}$ of approximately 1 mA, like the current source 100.

As the channel of transistors in a current source becomes larger, the output impedance of the current source increases such that the output current of the current source may be less sensitive to changes in the voltage across the transistor. Thus, in order to increase the output impedance of the current source 200 relative to the output impedance of the current source 100, the area of the channel of the transistor 202 may be increased. For example, the transistor 202 may have a channel width $W$ of approximately 400 $\mu$m and a channel length of approximately 240 nm. Thus, the total physical area or footprint of the current source 100 may be approximately 96 $\mu$m$^2$.

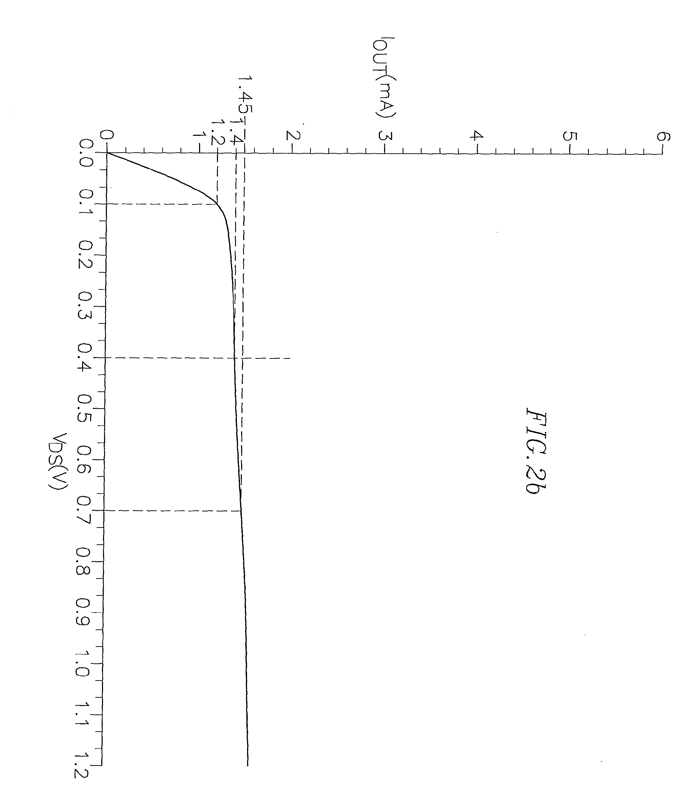

The relatively larger channel of the transistor 202 compared to the transistor 102 may facilitate the current source 200 having a relatively greater output impedance, as illustrated in FIG. 2b, which illustrates the current $I_{OUT}$ at the output terminal 204 of the current source 200 in relation to the voltage $V_{DS}$ across the large channel transistor 202. As shown in FIG. 2b, the current $I_{OUT}$ at the output terminal 204 of the current source 200, depending on the bias voltage $V_{BIAS}$, may be, for example, approximately 1.2 mA when the voltage $V_{DS}$ across the drain electrode 206 and the source electrode 214 of the long channel transistor 202 is approximately 0.1 V. Because the long channel transistor 202 is less sensitive to changes in the voltage $V_{DS}$, the output current $I_{OUT}$ may only increase from approximately 1.2 mA to approximately 1.4 mA as the voltage $V_{DS}$ increases from approximately 0.1 V to approximately 0.4 V. As the voltage $V_{DS}$ further increases from approximately 0.4 V to approximately 0.7 V, the output current $I_{OUT}$ may only increase from approximately 1.4 mA to approximately 1.45 mA. Accordingly, the output current $I_{OUT}$ of the current source 200 is relatively less sensitive to changes in the voltage $V_{DS}$ across the long channel transistor 202 compared to changes in the voltage $V_{DS}$ across the short channel transistor 102, and therefore has a relatively greater output impedance than the current source 100. In order to obtain the relatively greater output impedance, however, the physical area of the current source 200 may be, for example, approximately 8 times larger than the physical area of the current source 100 (e.g., 96 $\mu$m$^2$ versus 12 $\mu$m$^2$).

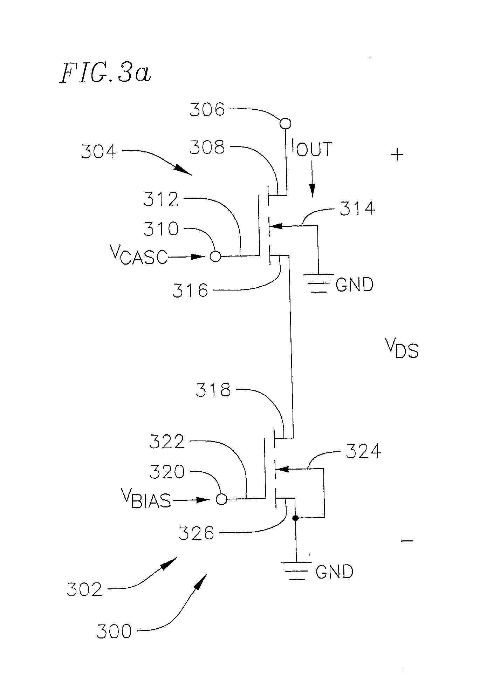

FIG. 3a illustrates a cascode current source 300 including a first short channel transistor 302 and a second short channel transistor 304, which are arranged in a cascode structure or arrangement. The cascode current source 300 has an output terminal 306 electrically coupled to a drain electrode 308 of the second short channel transistor 304. The cascode current source 300 has a cascode voltage input terminal 310 electrically coupled to a gate electrode 312 of the second short channel transistor 304, and a cascode voltage $V_{CASC}$ may be applied to the cascode voltage input terminal 310 to facilitate generating the output current $I_{OUT}$ at the output terminal 306. A bulk electrode 314 of the short channel transistor 304 is electrically coupled to a low voltage power supply or ground GND. A source electrode 316 of the second short channel transistor 304 is electrically coupled to a drain electrode 318 of the first short channel transistor 302. The cascode current source 300 further has a bias voltage input terminal 320 electrically coupled to a gate electrode 322 of the first short channel transistor 302, and a bias voltage $V_{BIAS}$ may be applied to the bias voltage input terminal 322 to facilitate generating the output current $I_{OUT}$ in conjunction with the cascode voltage $V_{CASC}$ at the output terminal 306. A bulk electrode 324 of the first short channel transistor 302 is electrically coupled to a source electrode 326 of the first short channel transistor 302, which is further coupled to a low voltage power supply or ground GND.

The first short channel transistor 302 and the second short channel transistor 304 may be manufactured using any suitable transistor manufacturing or fabrication technology and the cascode current source 300 may be configured to provide an output current $I_{OUT}$ according to the design and function of the cascode current source 300 depending on the cascode voltage $V_{CASC}$ and the bias voltage $V_{BIAS}$. For example, the cascode current source 300 may be configured to provide an output current $I_{OUT}$ of approximately 1 mA, like the current sources 100 and 200.

The cascode structure of the cascode current source 300 may enable greater output impedance of the cascode current source 300 relative to the current source 100, while enabling the cascode current source 300 to utilize transistors having a relatively small physical area or footprint. For example, the first short channel transistor 302 and the second short channel transistor 304 may each have a channel width $W$ of approximately 200 $\mu$m and a channel length L of approximately 60 nm, similar to the size of the short channel transistor 102 of the current source 100. Thus, the total physical area of the cascode current source 300 may be approximately 24 $\mu$m$^2$, as opposed to approximately 12 $\mu$m$^2$ for the current source 100, or approximately 96 $\mu$m$^2$ for the current source 200.

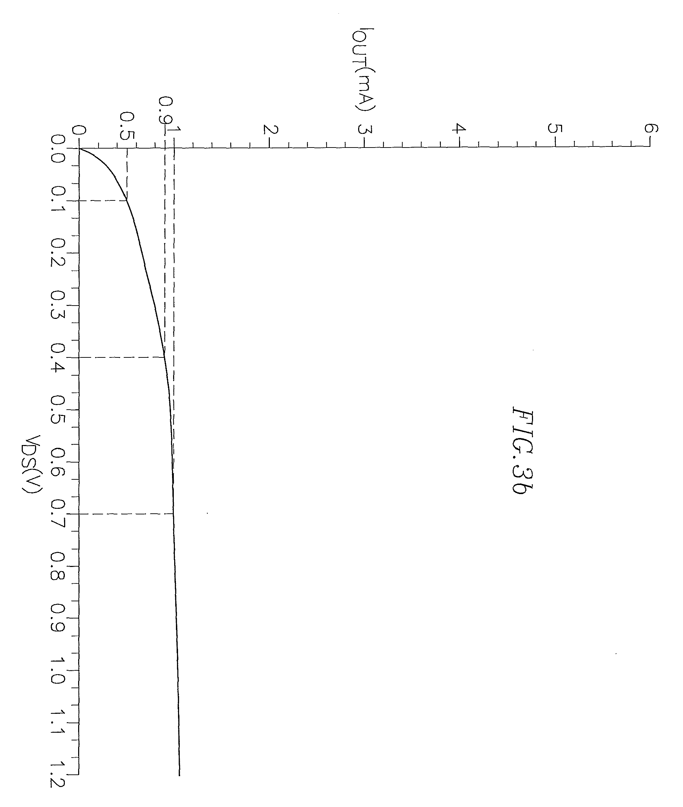

Thus, the cascode structure of the cascode current source 300 may enable a relatively greater output impedance than the current source 100, as illustrated in FIG. 3b, while reducing the total physical area or footprint of the device relative to that of the current source 200. As shown in FIG. 3b, the current $I_{OUT}$ at the output terminal 306 of the cascode current source 300, depending on the cascode voltage $V_{CASC}$ and the bias voltage $V_{BIAS}$ may be, for example, 0.5 mA when the voltage $V_{DS}$ across the drain electrode 308 of the second short channel transistor 304 and the source electrode 326 of the first short channel transistor 302 is approximately 0.1 V. Due to the cascode structure of the cascode current source 300, however, the cascode current source 300 may be less sensitive to changes in the voltage $V_{DS}$ such that the output current $I_{OUT}$ may only increase from approximately 0.5 mA to approximately 0.9 mA as the voltage $V_{DS}$ increases from approximately 0.1 V to approximately 0.4 V. As the voltage $V_{DS}$ further increases from approximately 0.4 V to approximately 0.7 V, the output current $I_{OUT}$ may only increase from approximately 0.9 mA to approximately 1 mA.

Accordingly, the output current $I_{OUT}$ of the cascode current source 300 is relatively less sensitive to changes in the voltage $V_{DS}$ compared to changes in the voltage $V_{DS}$ of the current source 100, and therefore the cascode current source 300 has a relatively greater output impedance than the current source 100. Furthermore, the cascode current source 300 has a relatively smaller physical area or footprint than the current source 200. However, as illustrated in FIG. 3b, the cascode current source 300 takes a relatively higher voltage $V_{DS}$ for the output current $I_{OUT}$ to reach approximately 1 mA. For example, as shown in FIG. 3b, the output current $I_{OUT}$ may not reach 1 mA until the voltage $V_{DS}$ is between 0.4 V and 0.8 V (e.g., 0.7 V as illustrated in FIG. 3b). By contrast, the long channel transistor of the current source 200 enabled the current source to reach approximately 1 mA before the voltage $V_{DS}$ reached 0.1 V.

As shown above with respect to equations (1) and (2) and as illustrated in FIGs. 1b, 2b, and 3b, however, the drain-to-source voltage $V_{DS}$ and the source-to-bulk voltage $V_{SB}$ have opposite effects on current. That is, as the voltage $V_{DS}$ across the transistors of a current source increases, the output current $I_{OUT}$ correspondingly increases (and vice versa). Further, as the source-to-bulk voltage $V_{SB}$ increases, the threshold voltage $V_T$ increases, and therefore, the output current $I_{OUT}$ decreases (and vice versa).

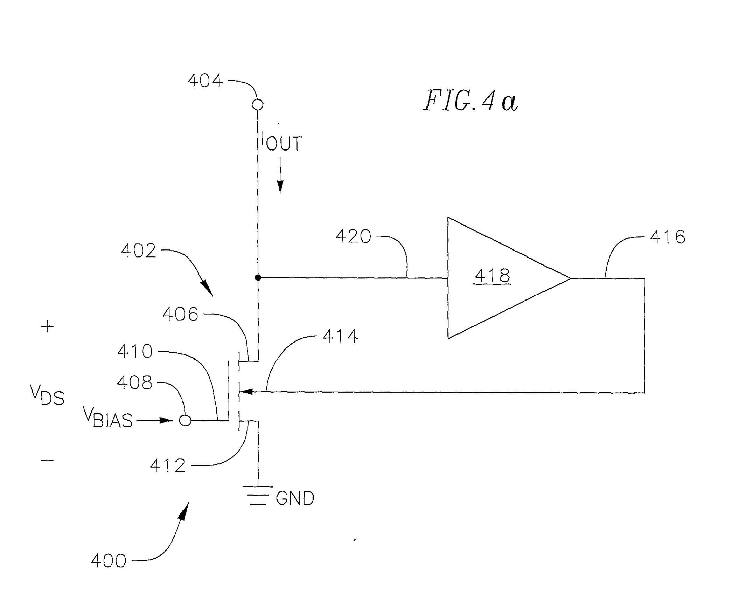

Accordingly, embodiments of the present invention utilize the above property to reduce the effect of changes in the voltage $V_{DS}$ on the output current $I_{OUT}$, as illustrated in FIG. 4a. FIG. 4a illustrates a bulk-modulated current source 400 according to an embodiment of the present invention. The bulk-modulated current source 400 has a first transistor 402, and an output terminal 404 electrically coupled to a drain electrode 406 of the first transistor 402. The bulk-modulated current source 400 further has a bias voltage input terminal 408 electrically coupled to a gate electrode 410 of the first transistor 402, and a bias voltage $V_{BIAS}$ may be applied to the bias voltage input terminal 408 to facilitate generation of the output current $I_{OUT}$ at the output terminal 404. A source electrode 412 of the first transistor 402 is electrically coupled to a low voltage power supply or ground GND.

Instead of being coupled to a power supply or the source electrode 412, the bulk electrode 414 of the first transistor 402 is electrically coupled to and driven by the output terminal 416 of an amplifier 418 having a negative gain -A, where A is in a range of approximately 0.5 to 2. The input terminal 420 of the amplifier 418 is electrically coupled to the output terminal 404 of the bulk-modulated current source 400. Thus, the bulk electrode 414 of the first transistor is driven by an output voltage corresponding to the output current $I_{OUT}$, which is amplified with a negative gain -A. The first transistor 402 may be manufactured using any suitable transistor manufacturing or fabrication technology and may be either NMOS or PMOS according to the design and function of the current source 400.

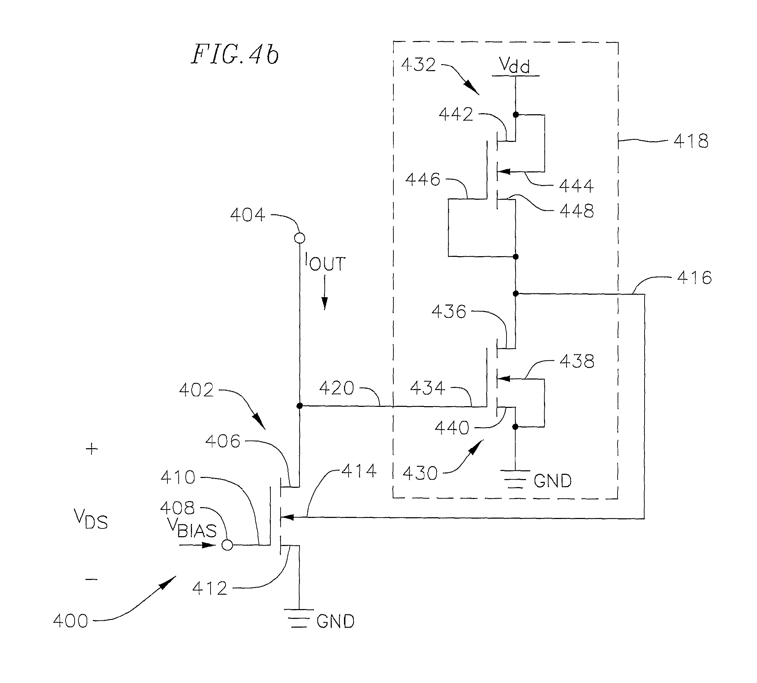

FIG. 4b illustrates further detail of the bulk-modulated current source 400. As shown in FIG. 4b, in one embodiment, the amplifier 418 of the bulk-modulated current source 400 includes a second transistor 430 and a third transistor 432. A gate electrode 434 of the second transistor 430 is electrically coupled to the input terminal 420 of the amplifier 418. A drain electrode 436 of the second transistor 430 is electrically coupled to the output terminal 416 of the amplifier 418 and further coupled to the bulk electrode 414 of the first transistor 402. A bulk electrode 438 of the second transistor 430 is electrically coupled to a source electrode 440 of the second transistor 430, which is further electrically coupled to a low voltage power supply or ground GND. Accordingly, the amplifier 418 constitutes a single stage amplifier having a negative gain -A equal to approximately $-\dfrac{g_{430}}{g_{432}}$, where $g_{430}$ is the transconductance of the second transistor 430

and $g_{432}$ is the transconductance of the third transistor 432. The amplifier of the bulk-modulated current source 400 is not limited to the embodiment shown in FIGs. 4a through 4d, and the amplifier 418 may be implemented using other suitable amplifier structures according to the design and function of the bulk-modulated current source 400.

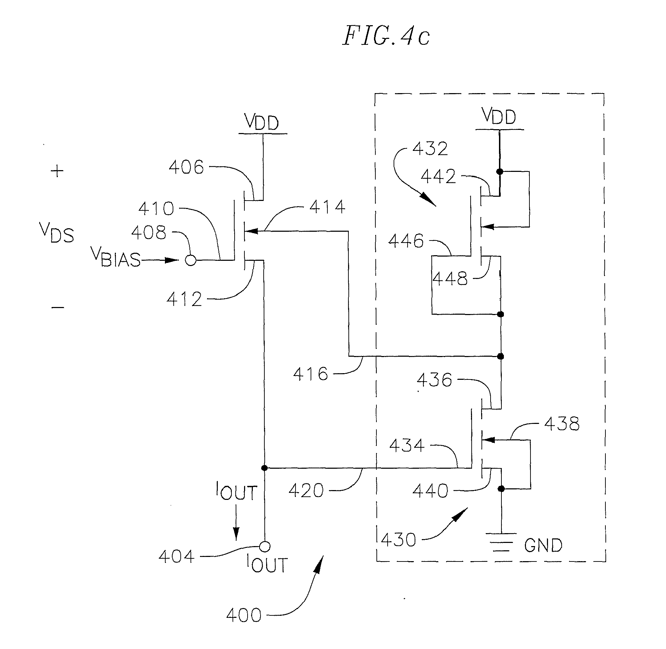

A source electrode 442 of the third transistor 432 is electrically coupled to a positive power supply $V_{DD}$. A bulk electrode 444 of the third transistor 432 is electrically coupled to the source electrode 442 and the positive power supply $V_{DD}$. A gate electrode 446 of the third transistor 432 is electrically coupled to a drain electrode 448 of the third transistor 432, the drain electrode 436 of the second electrode 430, and the output terminal 416 of the amplifier 418. Thus, the third transistor 432 may be a diode-coupled transistor operating as a load. The second transistor 430 and the third transistor 432 may be manufactured using any suitable transistor manufacturing or fabrication technology and may be NMOS and PMOS transistors, respectively. For example, as shown in FIG. 4b, the second transistor 430 is an NMOS transistor and the third transistor 432 is a PMOS transistor. FIG. 4c illustrates an alternative arrangement in which the first transistor 402 is a PMOS transistor. The drain electrode 406 is electrically coupled to the positive power supply VDD. The output terminal 404 of the bulk-modulated current source 400 and input terminal 420 of the amplifier 418 are electrically coupled to the drain electrode 412 of the first transistor 402.

Because the bulk electrode 414 of the first transistor 402 is electrically coupled to the output of the amplifier 418 having a gain of -A, the bulk electrode 414 of the first transistor 402 is driven by a voltage equal to -A x $V_{DS}$. Thus, the source-to-bulk voltage $V_{SB}$ of the first transistor 402 is driven by the output of the amplifier 418 such that the voltage $V_{SB}$ moves in the opposite direction of the voltage $V_{DS}$, therefore operating to counteract or reduce (e.g., mitigate) the effects of changes in the voltage $V_{DS}$ on the output current $I_{OUT}$. Furthermore, the negative gain -A of the amplifier 418 need not be a large value, and indeed may be in a range of -0.5 and -2.

Because the structure of the bulk-modulated current source 400 enables the effects of changes in the voltage $V_{DS}$ to be mitigated by driving the source-to-bulk voltage $V_{SB}$ with a gain of -A x $V_{DS}$, and because the negative gain -A of the amplifier 418 need not be a relatively large value, the physical area or footprint of the first transistor 402, the second transistor 430, and the third transistor 432 can be relatively small. For example, in order to provide the output current $I_{OUT}$ of approximately 1 mA, the channel width W of the first transistor 402 may be, for example, 42 $\mu$m or less, and the channel length L of the first transistor 402 may be, for example, 60 nm or less. The channel width W of the second transistor 430 may be, for example, 5 $\mu$m or less, and the channel length L of the second transistor 430 may be, for example, 60 nm or less. The channel width W of the third transistor 432 may be, for example, 20 $\mu$m or less, and the channel length L of the third transistor 432 may be, for example, 60 nm or less. Accordingly, the total physical area or footprint of the current source 400 may be approximately 4 $\mu$m$^2$, or less.

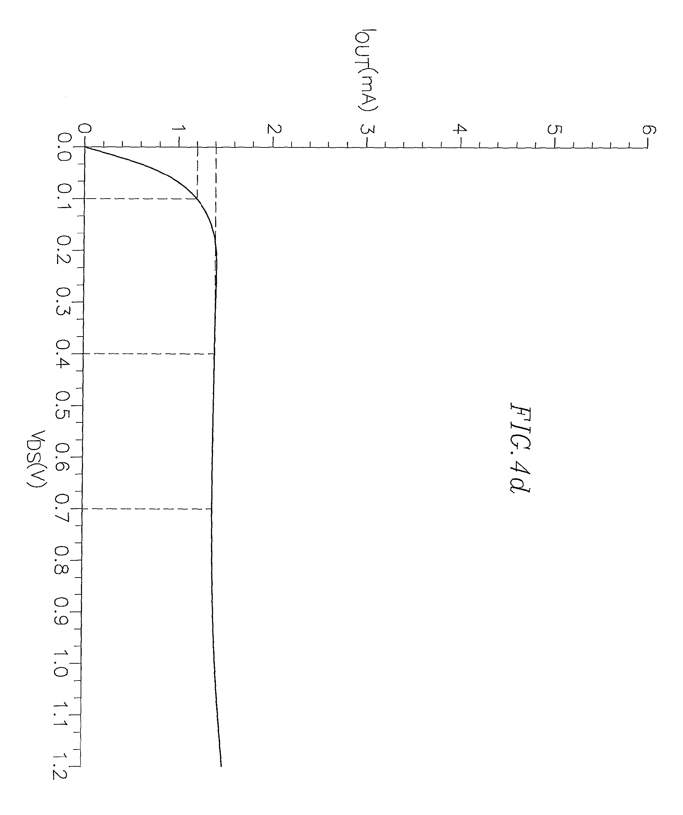

Additionally, because the effects of changes in the voltage $V_{DS}$ are offset by changes in the voltage $V_{SB}$, the bulk-modulated current source 400 has a greater impedance relative to the current source 100, as illustrated in FIG. 4d. For example, the output current $I_{OUT}$ at the output terminal 404 of the bulk-modulated current source 400, depending on the bias voltage $V_{BIAS}$, may reach approximately 1 mA when the voltage $V_{DS}$ is less than 0.1 V, and may reach approximately 1.2 mA when the voltage $V_{DS}$ is approximately 0.1 V. The output current $I_{OUT}$ may only increase from approximately 1.2 mA to approximately 1.4 mA when the voltage $V_{DS}$ increases from approximately 0.1 V to approximately 0.4 V. Finally, the output current $I_{OUT}$ may remain at approximately 1.4 mA when the voltage $V_{DS}$ increases from approximately 0.4 V to approximately 0.7 V. Accordingly, the output current $I_{OUT}$ is relatively less sensitive to changes in the voltage $V_{DS}$ compared to the current source 100 having a single small channel transistor 102.

As illustrated in Table 1 below, the structure of the bulk-modulated current source 400 provides a relatively larger output impedance relative to the current source 100, the current source 200, and the cascode current source 300, while also having a relatively smaller physical area or footprint.

Table 1

| **Current Source Type** | **Approximate Output Impedance ($\Omega$)** | **Total Physical Area ($\mu$m$^2$)** |
| --- | --- | --- |
| Current source 100 using single small channel transistor 102 | 0.2k | 12 |
| Current source 200 using single long channel transistor 202 | 5k | 96 |
| Current source 300 using cascode structure | 6k | 24 |
| Bulk-modulated current source 400 | 7k | 4 |

Thus, the bulk-modulated current source 400 may be able provide an output current $I_{OUT}$ having an approximate output impedance that is greater than that provided by current sources using a single small channel transistor, a single long channel transistor, or a cascode structure, while also having a total physical area that is approximately 1/3 or less of the total physical area of the current source using only a single small channel transistor. Accordingly, the bulk-modulated current source 400 may provide an output current $I_{OUT}$ at a relatively high output impedance, by driving the source-to-bulk voltage $V_{SB}$ with a voltage equal to a negative gain -A multiplied by the drain-to-source voltage $V_{DS}$.

While the present invention has been described in connection with certain embodiments thereof, it is to be understood that the invention is not limited to the disclosed embodiments, but, on the contrary, is intended to cover various modifications and equivalent arrangements included within the scope of the appended claims, and equivalents thereof.

**Claims**

1. A bulk-modulated current source comprising:

    a first transistor comprising:

        a first electrode, and
        a bulk electrode; and

    an amplifier comprising:

        an input terminal electrically coupled to the first electrode of the first transistor, and

an output terminal electrically coupled to the bulk electrode of the first transistor.

2. A bulk-modulated current source according to claim 1, further comprising an output terminal configured to supply an output current and coupled to the first electrode.

3. A bulk-modulated current source according to claim 1 or 2, wherein the first transistor further comprises a gate electrode configured to receive a bias voltage.

4. A bulk-modulated current source according to claim 1, 2 or 3, wherein the amplifier has a negative gain.

5. A bulk-modulated current source according to claim 4, wherein the negative gain of the amplifier is in a range of -0.5 to -2.

6. A bulk-modulated current source according to any preceding claim, wherein the amplifier further comprises:

   a second transistor comprising:

   a gate electrode electrically coupled to the first electrode of the first transistor, and
   a drain electrode electrically coupled to the output terminal of the amplifier; and

   a third transistor comprising:

   a source electrode electrically coupled to a power supply,
   a gate electrode, and
   a drain electrode, wherein the drain electrode of the third transistor is electrically coupled to the gate electrode of the third transistor and the drain electrode of the second transistor.

7. A bulk-modulated current source according to any preceding claim, wherein the first transistor is an NMOS transistor, and a second electrode of the first transistor is coupled to a low voltage power supply or ground.

8. A bulk-modulated current source according to one of claims 1 to 6, wherein the first transistor is a PMOS transistor, and a second electrode of the first transistor is coupled to a high voltage power supply.

9. A method of generating an output current using a bulk-modulated current source, the method comprising:

   generating an output current at an output terminal of the bulk-modulated current source;
   supplying an input terminal of an amplifier with a first output voltage corresponding to the output current; and
   driving a bulk terminal of the first transistor with a second output voltage generated by the amplifier.

10. A method according to claim 9, comprising applying a bias voltage to a gate electrode of a first transistor of the bulk-modulated current source, wherein a first electrode of the first transistor is electrically coupled to the output terminal of the bulk-modulated current source.

11. A method according to claim 10, wherein the amplifier further comprises:

    a second transistor comprising:

    a gate electrode electrically coupled to the first electrode of the first transistor, and
    a drain electrode electrically coupled to the output terminal of the amplifier; and

    a third transistor comprising:

    a source electrode electrically coupled to a power supply,
    a gate electrode, and
    a drain electrode, wherein the drain electrode of the third transistor is electrically coupled to the gate electrode of the third transistor and the drain electrode of the second transistor.

12. A method according to claim 10 or 11, wherein the first transistor is an NMOS transistor, and a second electrode of the first transistor is coupled to a low voltage power supply or ground.

13. A method according to claim 10 or 11, wherein the first transistor is a PMOS transistor, and a second electrode of the first transistor is coupled to a high voltage power supply.

14. A method according to one of claims 9 to 13, wherein the amplifier has a negative gain.

15. A method according to claim 14, wherein the negative gain of the amplifier is in a range of -0.5 to -2.

*FIG.1α*

100

102

VBIAS

108

110

114

104

106

IOUT

112

V$_{DS}$

GND

+

−

FIG.1b

FIG.2a

*FIG.2b*

EP 2 824 534 A2

FIG.3a

FIG.36

FIG.4 a

FIG. 4b

FIG.4c

FIG. 4d